(19) Europäisches Patentamt

European Patent Office

Office européen des brevets

(11) **EP 4 585 935 A1**

(12) **EUROPEAN PATENT APPLICATION**

(43) Date of publication:
**16.07.2025 Bulletin 2025/29**

(21) Application number: **24151037.9**

(22) Date of filing: **09.01.2024**

(51) International Patent Classification (IPC):
**G01R 31/28** (2006.01)     **H04L 7/027** (2006.01)

(52) Cooperative Patent Classification (CPC):
**G01R 31/2822; H04B 17/0085; H04B 17/295**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Rohde & Schwarz GmbH & Co. KG
81671 München (DE)**

(72) Inventors:
- **Hirschmann, Susanne
  81671 München (DE)**
- **Ramian, Florian
  81671 München (DE)**

(74) Representative: **Prinz & Partner mbB
Patent- und Rechtsanwälte
Rundfunkplatz 2
80335 München (DE)**

(54) **MEASUREMENT INSTRUMENT**

(57) A measurement instrument (14) is described. The measurement instrument (14) comprises at least one input port (16) and a measurement module (18). The input port (16) is configured to receive a radio frequency (RF) signal from a device under test (12), wherein the RF signal comprises a symbol sequence. The measurement module (18) is configured to receive the RF signal from the input port (16). The measurement module (18) comprises a reference signal module (26), wherein the reference signal module (26) is configured to generate a reference signal based on the received RF signal, wherein the reference signal comprises an extracted symbol sequence corresponding to the symbol sequence of the RF signal. The measurement module (18) further comprises an error module (30), wherein the error module (30) is configured to determine error vectors based on the RF signal and based on the reference signal. The measurement module (18) further comprises an analysis module (32), wherein the analysis module (32) is configured to determine whether the reference signal is correct based on the determined error vectors.

**Fig. 1**

**Description**

The present invention generally relates to a measurement instrument
For different types of measurement applications, a reference signal that corresponds to an ideal version of a received RF signal is extracted from the RF signal.

For these measurements to be correct, it is required that the extracted reference signal comprises the same symbol sequence as the RF signal.

Under certain circumstances, e.g. if the RF signal has a low signal-to-noise ratio, detection errors may occur, i.e. individual symbols of the symbol sequence in the extracted reference signal may be incorrect.

In the state of the art, the actual symbol sequence comprised in the RF signal has to be known in order to avoid or correct such detection errors.

However, there are situations where the actual symbol sequence is not known. In these measurement scenarios, the detection errors describe above cannot be corrected reliably.

Thus, the object of the present invention is to provide a measurement instrument that is capable of reliably detecting detection errors.

According to the present invention, the problem is solved by a measurement instrument. The measurement instrument comprises at least one input port and a measurement module. The input port is configured to receive a radio frequency (RF) signal from a device under test, wherein the RF signal comprises a symbol sequence. The measurement module is configured to receive the RF signal from the input port. The measurement module comprises a reference signal module, wherein the reference signal module is configured to generate a reference signal based on the received RF signal, wherein the reference signal comprises an extracted symbol sequence corresponding to the symbol sequence of the RF signal. The measurement module further comprises an error module, wherein the error module is configured to determine error vectors based on the RF signal and based on the reference signal. The measurement module further comprises an analysis module, wherein the analysis module is configured to determine whether the reference signal is correct based on the determined error vectors.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Further, the term "error vector" is understood to denote a vector that is equal to a difference between the RF signal and the reference signal at a certain point, namely at the symbol instance. More precisely, each error vector is equal to a difference between a sample of the RF signal and the corresponding sample of reference signal.

For example, if the RF signal is an IQ modulated signal, each error vector is a difference between one of samples of the RF signal and the corresponding constellation point.

The present invention is based on the finding that the correctness of the reference signal can be assessed based on the determined error vectors, as will be described in more detail hereinafter.

Therein, it is not necessary to know the actual symbol sequence that is comprised in the RF signal.

Instead, the correctness of the reference signal and thus the correctness of measurements performed can be assessed based on the RF signal and the extracted reference signal alone.

Thus, the measurement instrument according to the present invention is capable of detecting errors in the extracted reference signal even if details of the RF signal, particularly the symbol sequence comprised in the RF signal, are unknown.

According to an aspect of the present invention, the analysis module is configured to determine an error distribution based on the error vectors, wherein the analysis module is configured to determine whether the reference signal is correct based on the determined error distribution. In general, an error distribution that is associated with a certain type of errors in the RF signal has a certain expected shape. Conversely, if the shape of the error distribution significantly differs from the expected shape, it can be concluded that an additional error has occurred, particularly an error in the extracted reference signal.

For example, uncorrelated noise in the RF signal is expected to cause the error distribution to have the shape of a normal distribution or rather the shape of a multivariate normal distribution. If the error distribution significantly differs from the multivariate normal distribution, it may be concluded that a detection error has occurred, i.e. that at least one symbol of the extracted reference signal is incorrect.

In an embodiment of the present invention, the reference signal module is configured to demodulate the RF signal, thereby obtaining a demodulated RF signal, wherein the reference signal module is configured to generate the reference signal based on the demodulated RF signal. By demodulating the RF signal, the individual symbols comprised in the RF signal can be extracted. The reference signal can then be generated based on the extracted symbols, namely as an ideal version of the RF signal comprising the extracted symbols.

Therein, the modulation scheme on which the RF signal is based may be known or unknown.

According to another aspect of the present invention, the analysis module is configured to determine at least one analysis parameter, wherein the at least one analysis parameter is associated with the RF signal, and wherein the analysis module is configured to determine at least one statistical parameter associated with the at least one analysis parameter based on the determined error vectors, wherein the at least one statistical parameter is indicative of a measurement uncertainty with respect to the at least one analysis parameter. In other words, the measurement instrument may be configured to assess the accuracy of measurements conducted on the RF signal based on the determined error vectors, wherein the at least one statistical parameter is a measure for the measurement accuracy or rather the measurement uncertainties.

In general, the at least one analysis parameter is a parameter that is indicative of a signal quality of the RF signal and thus of a performance of the device under test generating the RF signal.

For example, the at least one analysis parameter may be or comprise an error vector magnitude (EVM).

The measurement instrument may further comprise a visualization module, wherein the visualization module is configured to generate joint visualization data for the at least one analysis parameter and for the at least one statistical parameter. Thus, information on the at least one analysis parameter and on the at least one statistical parameter may be visualized together, such that the information on the at least one analysis parameter and on the at least one statistical parameter is displayed to an user of the measurement instrument in an illustrative way.

The measurement instrument may comprise a display that is configured to display the joint visualization data.

Alternatively or additionally, the measurement instrument may be connectable to an external display that is configured to display the joint visualization data.

The visualization data may further comprise a warning signal, such as a text message and/or a warning sign, if the analysis module detects that the extracted reference signal is incorrect. Thus, the user is warned that the measurements performed may be incorrect or even invalid.

Another aspect of the present invention provides that the analysis module is configured to estimate a symbol error rate of the RF signal based on the determined error vectors. In fact, the symbol error rate can be estimated based on the determined error vectors without an actual symbol error occurring in the RF signal. This way, the measurement time for determining the symbol error rate of the RF signal can be reduced significantly, as the analysis module does not have to wait for a statistically significant amount of errors to have occurred. This is particularly advantageous for RF signals that have a low symbol error rate.

In an embodiment of the present invention, the analysis module is configured to determine an error distribution based on the error vectors, wherein the analysis module is configured to estimate the symbol error rate of the RF signal based on the determined error distribution. In fact, the symbol error rate can be estimated based on the determined error distribution without an actual symbol error occurring in the RF signal. This way, the measurement time for determining the symbol error rate of the RF signal can be reduced significantly, as the analysis module does not have to wait for a statistically significant amount of errors to have occurred. This is particularly advantageous for RF signals that have a low symbol error rate.

In a further embodiment of the present invention, the analysis module is configured to estimate the symbol error rate based on portions of the determined error distribution that are outside of decision boundaries, particularly wherein the analysis module is configured to integrate over the portions of the determined error distribution that are outside of the decision boundaries in order to estimate the symbol error rate. The decision boundaries represent lines in the IQ plane that separate the individual possible symbol values. Accordingly, by evaluating the error distribution over the portions outside of the respective decision boundaries, particularly by integrating the error distribution over the portions outside of the respective decision boundaries, a measure for the probability of a constellation point lying outside of the decision boundaries is obtained, which corresponds to the probability of a symbol error.

The analysis module may be configured to determine whether the reference signal is correct based on additional system information. This way, the accuracy of the detection of symbol errors in the extracted reference signal may be enhanced.

Particularly, the additional system information may relate to what type of errors are to be expected in the RF signal. For example, the additional system information may comprise the type of noise to be expected, e.g. only uncorrelated noise. As another example, the additional system information may comprise information on whether non-linear behavior of the RF signal is to be expected.

In an embodiment of the present invention, the symbol sequence comprised in the RF signal is unknown to the measurement module. Thus, the measurement instrument is configured to detect errors in the extracted reference signal without a priori knowledge of the symbol sequence comprised in the RF signal. Accordingly, measurements can be conducted reliably even if the symbol sequence is unknown.

According to an aspect of the present invention, a modulation scheme of the RF signal is unknown to the measurement module. In fact, the measurement module may be configured to determine the modulation scheme of the RF signal based on the RF signal, particularly based on a constellation diagram of the RF signal. Thus, the measurement instrument is configured to detect errors in the extracted reference signal without a priori knowledge of the modulation scheme of the RF signal.

In a further embodiment of the present invention the analysis module is configured to determine erroneous error vectors, particularly erroneous components of the erroneous error vectors. In other words, the analysis module may be configured to identify the individual error vectors that are incorrect, i.e. error vectors that refer to a falsely extracted symbol value.

Particularly, the analysis module is configured to correct the determined erroneous error vectors. This way, the accuracy of measurements conducted on the RF signal can be enhanced, as the erroneous error vectors may be corrected for the measurements.

For example, the accuracy of the at least one analysis parameter described above can be enhanced, as the erroneous error vectors may be corrected before determining the at least one analysis parameter.

As another example, the symbol error rate can be estimated with enhanced accuracy, as the erroneous error vectors may be corrected before determining the error distribution.

In another embodiment of the present invention, the analysis module is configured to discard the determined erroneous error vectors. This way, the accuracy of measurements conducted on the RF signal can be enhanced, as the erroneous error vectors may be discarded for the measurements.

For example, the accuracy of the at least one analysis parameter described above can be enhanced as the erroneous error vectors may be discarded before determining the at least one analysis parameter.

As another example, the symbol error rate can be estimated with enhanced accuracy, as the erroneous error vectors may be discarded before determining the error distribution.

A further aspect of the present disclosure provides that the measurement instrument is a signal analyzer, a spectrum analyzer, or an oscilloscope. However, it is to be understood that the measurement instrument may be established as any other suitable type of measurement instrument.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows a measurement system with a measurement instrument according to the present invention;

- Figure 2 schematically shows an exemplary constellation diagram of an RF signal;

- Figure 3 shows a single constellation point of the constellation diagram 4 in more detail;

- Figure 4 shows the constellation point of Figure 2 with an additional error being present; and

- Figure 5 shows the constellation point of Figure 2 with the associated decision boundaries.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

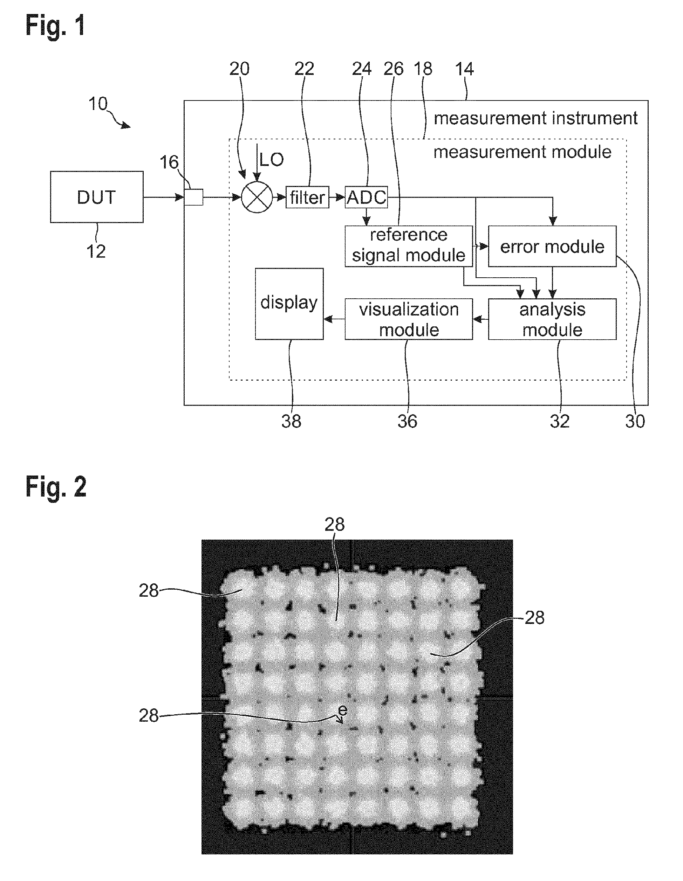

Figure 1 schematically shows a measurement system 10 comprising a device under test (DUT) 12 and a measurement instrument 14.

In general, the device under test 12 may be any type of electronic device that is configured to generate an RF signal or that is configured to process an input signal, thereby obtaining an RF signal, wherein the RF signal is an IQ modulated signal.

For example, the device under test 12 may be an amplifier, an attenuator, a filter, or a mixer.

As another example, the device under test 12 may be a signal generator, a mobile communication device, a network device such as a router, etc.

However, it is to be understood that the device under test 12 may be any other type of electronic device being configured to generate and/or process RF signals comprising a symbol sequence.

Generally, the measurement instrument 14 is configured to conduct measurements on the device under test 12 in order to assess a performance of the device under test 12.

The measurement instrument 14 comprises an input port 16 that is configured to receive an output signal of the device under test 12, i.e. the RF signal described above.

It is noted that the measurement instrument 14 may, of course, comprise further input ports.

In the exemplary embodiment shown in Figure 1, an output of the device under test 12 is connected to the input port 16 by a cable.

However, it is to be understood that a wireless connection between the device under test 12 and the measurement instrument 14 is also possible. In this case, the input port 16 may comprise or be connected to an RF antenna that is configured to receive the wireless RF signal from the device under test 12.

The measurement instrument 14 further comprises a measurement module 18 that is connected to the input port 16 so as to receive the RF signal.

Optionally, the measurement module 18 may comprise a mixer module 20 that is configured to down-convert a frequency of the RF signal by mixing the RF signal with a local oscillator (LO) signal.

Optionally, the measurement module 18 may further comprise a filter module 22 that is configured to filter the down-converted RF signal.

Hereinafter, the term "RF signal" is used to denote the RF signal received from the device under test 12 or the down-converted RF signal, depending on whether the mixer module 20 and the filter module 22 are provided or not.

The measurement module 18 further comprises an analog-to-digital converter (ADC) 24 that is configured to digitize the RF signal, thereby obtaining a digitized RF signal.

Downstream of the ADC 24, a reference signal module 26 is provided.

In general, the reference signal module 26 is configured to generate a reference signal based on the digitized RF signal, wherein the reference signal comprises an extracted symbol sequence corresponding to the symbol sequence of the RF signal.

In fact, the reference signal module 26 may first demodulate the digitized RF signal, thereby obtaining a demodulated RF signal, and may then generate the reference signal based on the demodulated RF signal.

Therein, the modulation scheme of the RF signal may be known, i.e. the reference signal module 26 may demodulate the RF signal based on the a priori known modulation scheme.

If the modulation scheme of the RF signal is not known, the reference signal module 26 may determine the modulation scheme based on the digitized RF signal, particularly based on a constellation diagram of the digitized RF signal.

As is exemplarily illustrated in Figure 2, the constellation diagram of the digitized RF signal typically comprises samples of the digitized RFs signal that aggregate around the different possible constellation points 28 that correspond to the different possible symbol values.

Conversely, the different possible constellation points 28, and thus the modulation scheme, can be derived from the distribution of the samples of the digitized RF signal in the constellation diagram, i.e. in the IQ plane.

The reference signal module 26 extracts the symbols comprised in the demodulated RF signal and generates a corresponding ideal version of the RF signal comprising the same symbol sequence, i.e. the reference signal.

Therein, no a priori knowledge of the symbol sequence comprised in the RF signal is required.

As is shown in Figure 1, the measurement module 18 further comprises an error module 30 that is connected to the reference signal module 26 so as to receive the generated reference signal.

The error module 30 further is connected to the ADC 24 so as to receive the digitized RF signal.

Generally, the error module 30 is configured to determine error vectors based on the digitized RF signal and based on the generated reference signal.

Each error vector corresponds to a difference between an actual value of a sample of the digitized RF signal and the corresponding sample of the reference signal.

As is illustrated exemplarily for one sample in Figure 2, the error vector e corresponds to the vector from the ideal sample value, namely from the associated constellation point 28, to the actual sample value.

The determined error vectors are forwarded to an analysis module 32 that is provided downstream of the error module 30.

The analysis module 32 further may be connected to the ADC 24 so as to receive the digitized RF signal.

Moreover, the analysis module 32 may be connected to the reference signal module 26 so as to receive the reference signal.

In general, the analysis module 32 is configured to determine whether the reference signal is correct based on the error vectors determined by the error module 30.

More precisely, the analysis module 32 is configured to determine an error distribution based on the error vector, wherein the error distribution $D(I,Q)$ describes the number or rather the density of error vectors as a function of I and Q, i.e. of the variables that span the IQ-plane.

Typically, the error distribution has the shape of a multivariate normal distribution around the individual constellation points 28.

More precisely, the error distribution typically has the shape of a bivariate normal distribution around the individual constellation points 28.

Accordingly, the error distribution for the whole IQ plane may be a superposition of the bivariate normal distributions around the individual constellation points 28.

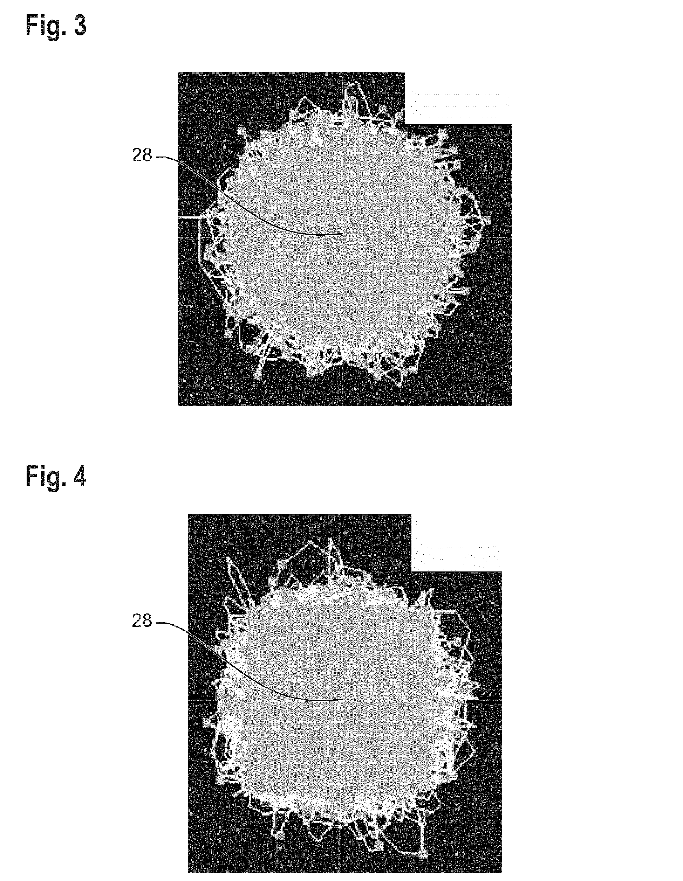

As is illustrated in Figure 3, which shows a single constellation point 28 of the constellation diagram of Figure 2, this corresponds to an approximately circular distribution of the individual sample points around the constellation points 28.

If the determined error distribution matches the typical shape described above for all constellation points 28, it may be concluded that the extracted reference signal is correct.

If, however, the determined error distribution differs significantly from the typical shape described above for at least one of the constellation points 28, it may be concluded that there is an additional error, particularly that there is an error in the extracted reference signal.

In fact, the analysis module 32 may determine whether the extracted reference signal is correct based on the error distribution and based on additional system information.

Particularly, the additional system information may relate to what type of errors are to be expected in the RF signal. For example, the additional system information may comprise the type of noise to be expected, e.g. only uncorrelated noise. As another example, the additional system information may comprise information on whether non-linear behavior of the RF signal is to be expected.

Different types of errors are usually associated with different shapes of the resulting error distribution. Accordingly, if the error distribution differs from the expected shape taking into account the additional system information, it can be concluded that at least one symbol of the extracted reference signal is incorrect.

As is exemplarily illustrated in Figure 4, a deviation of the error distribution from the shape of the bivariate normal distribution may also be visible in the constellation diagram.

In the specific example shown in Figure 4, the distribution of samples around the shown constellation point 28 differs from a circular distribution and has an approximately rectangular shape.

The analysis module 32 may further be configured to estimate a symbol error rate of the RF signal based on the determined error vectors or rather based on the determined error distribution.

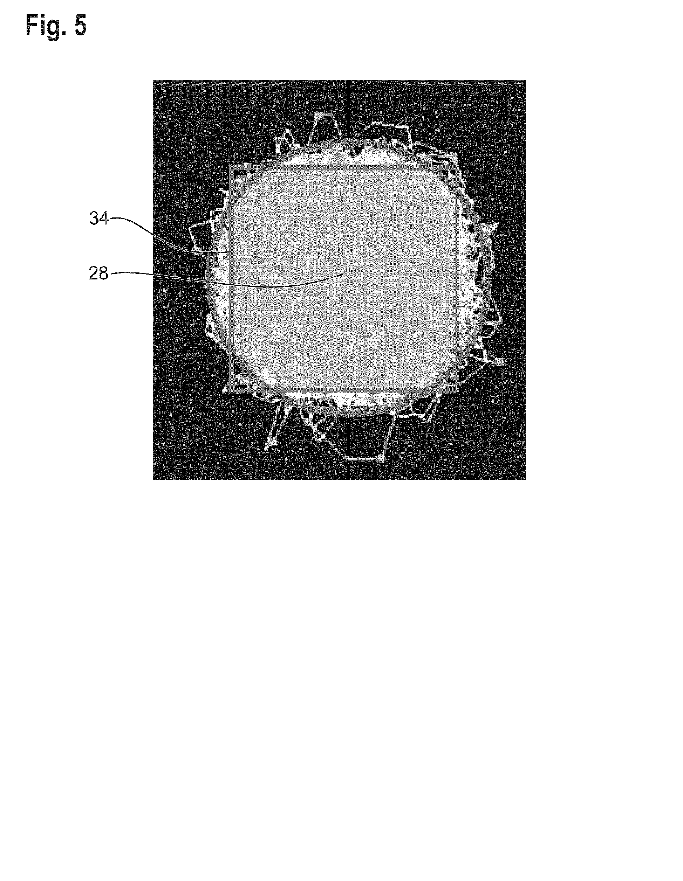

As is illustrated in Figure 5, there are decision boundaries 34 for each of the constellation points 28, which represent lines in the IQ plane that separate the individual possible symbol values.

The symbol error rate (SER) can be estimated based on portions of the determined error distribution D(I,Q) that are outside of the decision boundaries 34, namely by evaluating the portions of the determined error distribution D(I,Q) that are outside of the decision boundaries 34.

In fact, the SER may be estimated by integrating the error distribution D(I,Q) over portions of the error distribution that are outside of the decision boundaries 34. It holds

$$SER \propto \frac{\int_{A_1} D(I,Q)dIdQ}{\int D(I,Q)dIdQ}.$$

Therein, the area $A_1$ is the area outside of the decision boundaries 34, while the integral in the denominator spans the whole portion of the IQ plane being relevant for the error distribution, particularly the whole IQ plane.

Using this way of calculating the estimated symbol error rate, the symbol error rate can be estimated based on the determined error vectors or rather based on the determined error distribution without an actual symbol error occurring in the RF signal, as no actual symbol error is required to determine the error distribution.

The analysis module 32 may further be configured to determine at least one analysis parameter based on the determined error vectors, based on the reference signal, and/or based on the digitized RF signal.

In general, the at least one analysis parameter is a parameter that is indicative of a performance of the device under test 12 or rather a signal quality of the RF signal.

For example, the at least one analysis parameter may be or comprise an error vector magnitude.

The analysis module 32 may further be configured to determine at least one statistical parameter associated with the at least one analysis parameter based on the determined error vectors, wherein the at least one statistical parameter is indicative of a measurement uncertainty with respect to the at least one analysis parameter.

For example, the at least one statistical parameter may be or comprise a standard deviation, a variance, and/or higher statistical moments.

In order to enhance the accuracy of the measurements described above, the analysis module 32 may be configured to determine erroneous error vectors, particularly erroneous components of the erroneous error vectors.

Such erroneous error vectors may occur if a symbol of the reference signal has been decided incorrectly, such that the corresponding error vectors refer to the wrong constellation point 28.

The analysis module 32 may correct the erroneous error vectors for determining the at least on analysis parameter, the at least one statistical parameter, the error distribution, and/or the estimated symbol error rate.

The measurement module 18 further comprises a visualization module 36 that is connected to the analysis module 32.

The visualization module 36 is configured to generate joint visualization data for the at least one analysis parameter and for the at least one statistical parameter.

The joint visualization data may further comprise visualization data for the estimated symbol error rate.

The joint visualization data may further comprise a warning signal, such as a text message and/or a warning sign, if the analysis module detects that the extracted reference signal is incorrect.

The joint visualization data may be displayed on a display 38 that is integrated into the measurement instrument 14.

Alternatively or additionally, the joint visualization data may be displayed on a display that is connected to the measurement instrument 14.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A measurement instrument, wherein the measurement instrument (14) comprises at least one input port (16) and a measurement module (18),

    wherein the input port is configured to receive a radio frequency (RF) signal from a device under test (12), wherein the RF signal comprises a symbol sequence,
    wherein the measurement module (18) is configured to receive the RF signal from the input port (16),
    wherein the measurement module (18) comprises a reference signal module (26), wherein the reference signal module (26) is configured to generate a reference signal based on the received RF signal, wherein the reference signal comprises an extracted symbol sequence corresponding to the symbol sequence of the RF signal,
wherein the measurement module (18) further comprises an error module (30), wherein the error module (30) is configured to determine error vectors based on the RF signal and based on the reference signal, and
wherein the measurement module (18) further comprises an analysis module (32), wherein the analysis module (32) is configured to determine whether the reference signal is correct based on the determined error vectors.

2. The measurement instrument of claim 1, wherein the analysis module (32) is configured to determine an error distribution based on the error vectors, and wherein the analysis module (32) is configured to determine whether the reference signal is correct based on the determined error distribution.

3. The measurement instrument according to any one of the preceding claims, wherein the reference signal module (26) is configured to demodulate the RF signal, thereby obtaining a demodulated RF signal, and wherein the reference signal module (26) is configured to generate the reference signal based on the demodulated RF signal.

4. The measurement instrument according to any one of the preceding claims, wherein the analysis module (32) is configured to determine at least one analysis parameter, wherein the at least one analysis parameter is associated with the RF signal, and wherein the analysis module (32) is configured to determine at least one statistical parameter associated with the at least one analysis parameter based on the determined error vectors, wherein the at least one statistical parameter is indicative of a measurement uncertainty with respect to the at least one analysis parameter.

5. The measurement instrument of claim 4, further comprising a visualization module (36), wherein the visualization module (36) is configured to generate joint visualization data for the at least one analysis parameter and for the at least one statistical parameter.

6. The measurement instrument according to any one of the preceding claims, wherein the analysis module (32) is configured to estimate a symbol error rate of the RF signal based on the determined error vectors.

**7.** The measurement instrument of claim 6, wherein the analysis module (32) is configured to determine an error distribution based on the error vectors, and wherein the analysis module (32) is configured to estimate the symbol error rate of the RF signal based on the determined error distribution.

**8.** The measurement instrument of claim 7, wherein the analysis module (32) is configured to estimate the symbol error rate based on portions of the determined error distribution that are outside of decision boundaries (34), particularly wherein the analysis module (32) is configured to integrate over the portions of the determined error distribution that are outside of the decision boundaries (34) in order to estimate the symbol error rate.

**9.** The measurement instrument according to any one of the preceding claims, wherein the analysis module (32) is configured to determine whether the reference signal is correct based on additional system information.

**10.** The measurement instrument according to any one of the preceding claims, wherein the symbol sequence comprised in the RF signal is unknown to the measurement module (18).

**11.** The measurement instrument according to any one of the preceding claims, wherein a modulation scheme of the RF signal is unknown to the measurement module (18).

**12.** The measurement instrument according to any one of the preceding claims, wherein the analysis module (32) is configured to determine erroneous error vectors, particularly erroneous components of the erroneous error vectors.

**13.** The measurement instrument of claim 12, wherein the analysis module (32) is configured to correct the determined erroneous error vectors.

**14.** The measurement instrument of claim 12, wherein the analysis module (32) is configured to discard the determined erroneous error vectors.

**15.** The measurement instrument according to any one of the preceding claims, wherein the measurement instrument (14) is a signal analyzer, a spectrum analyzer, or an oscilloscope.

# Fig. 1

# Fig. 2

Fig. 3

Fig. 4

# Fig. 5

Europäisches
Patentamt

European
Patent Office

Office européen
des brevets

**EUROPEAN SEARCH REPORT**

Application Number

EP 24 15 1037

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/076072 A1 (MUTO MASAHIKO [JP]) 7 April 2005 (2005-04-07) | 1,3-6, 9-15 | INV. G01R31/28 H04L7/027 |
| A | * paragraphs [0035] - [0042], [0059] - [0094], [0097] - [0104]; figures 1-2, 8 * | 2,7,8 | |
| A | US 2021/266243 A1 (PETROVIC NIELS [DE] ET AL) 26 August 2021 (2021-08-26) * paragraphs [0055] - [0072]; claim 1; figures 1, 2, 4 * | 1-15 | |
| A | US 2015/304075 A1 (AHMED I ZAKIR [IN] ET AL) 22 October 2015 (2015-10-22) * paragraphs [0034] - [0096]; figures 1-4 * | 1-15 | |
| A | CN 103 490 824 A (41ST INST CHINA ELECTRONICS TECHNOLOGY GROUP CORP) 1 January 2014 (2014-01-01) * the whole document * | 1-15 | |
| A | US 2016/006557 A1 (SHIRAKAWA YOSHINORI [JP] ET AL) 7 January 2016 (2016-01-07) * paragraphs [0128] - [0136]; figures 6-8 * | 1-15 | TECHNICAL FIELDS SEARCHED (IPC) G01R H04L |

The present search report has been drawn up for all claims

| Place of search | Date of completion of the search | Examiner |
|---|---|---|
| Munich | 28 June 2024 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2024

| Patent document cited in search report | | Publication date | Patent family member(s) | | Publication date |
|---|---|---|---|---|---|
| US 2005076072 | A1 | 07-04-2005 | CN | 1493135 A | 28-04-2004 |
| | | | DE | 10296365 T5 | 22-04-2004 |
| | | | JP | 2002247119 A | 30-08-2002 |
| | | | US | 2005076072 A1 | 07-04-2005 |
| | | | WO | 02067523 A1 | 29-08-2002 |
| US 2021266243 | A1 | 26-08-2021 | NONE | | |
| US 2015304075 | A1 | 22-10-2015 | NONE | | |
| CN 103490824 | A | 01-01-2014 | NONE | | |
| US 2016006557 | A1 | 07-01-2016 | US | 2016006557 A1 | 07-01-2016 |
| | | | WO | 2014132599 A1 | 04-09-2014 |

EPO FORM P0459

For more details about this annex : see Official Journal of the European Patent Office, No. 12/82